# EUROPEAN PATENT APPLICATION

(11) **EP 4 471 860 A1**
(43) Date of publication of application: **04.12.2024**
(21) Application number: 24170828.8
(22) Date of filing: 17.04.2024
(51) Int. Cl.: H01L 27/02, H01L 29/10

(54) **ESD CIRCUIT WITH GGNMOS TRANSISTORS HAVING MULTIPLE BODY CONTACT REGIONS**

(30) Priority: 30.05.2023 US 202318325503
(71) Applicant: NXP B.V., 5656 AG Eindhoven (NL)
(72) Inventor: de Raad, Gijs Jan, 5656 AG Eindhoven (NL); Quax, Guido Wouter Willem, 5656 AG Eindhoven (NL)
(74) Representative: Schmütz, Christian Klaus Johannes

(57) **Abstract**

An electrostatic discharge circuit includes two or more GGNMOS transistors where each transistor includes two types of body contact regions. Body contact regions of one type are non substrate isolated from body contact regions of the other type. A body contact region of one type is electrically coupled to the source region of its transistor and a body contact region of the other type is electrically connected to at least one other body contact region of the same type of another GGNMOS transistor.

## Description

### BACKGROUND OF THE INVENTION

### Field of the Invention

This invention relates to an ESD circuit with GGNMOS transistors having multiple body contact regions.

### Background

Some semiconductor die utilize electrostatic discharge (ESD) clamp devices for discharging charge from an ESD event affecting a die terminal. One example of an ESD clamp device is a grounded gate NMOS(GGNMOS) transistor. A GGNMOS is an NMOS transistor in which the gate is electrically coupled to the source or biased at a voltage that is less than the bias voltage of the source.

An ESD event may occur when a charged object (e.g., a human finger) inadvertently contacts a conductive surface of a semiconductor die (e.g., a contact pad) or a conductive surface of a semiconductor die package coupled to the pad where charge at an elevated voltage is applied to the conductive surface due to the contact. Being at an elevated voltage, such charge may cause voltage differentials across the devices of the integrated circuit that may exceed their safe operating areas and damage those devices. An ESD event may also occur when a charged conductive surface of a circuit contacts an external object where charge is transferred between the conductive surface and the external object.

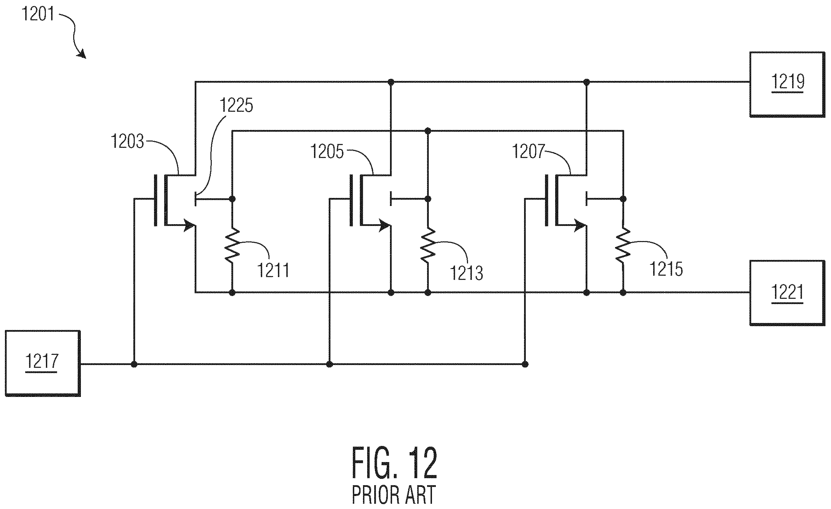

Figure 12 is a circuit diagram of a prior art circuit that include three NMOS transistors 1203, 1205, and 1207 that are substrate isolated from each other. The gates of the three transistors are electrically connected to pad 1217. The drain regions of the three transistors are electrically connected to pad 1219. The source regions of the three transistors are electrically connected to pad 1221. The body contact regions (1225) of each transistor are electrically connected to each other and are each electrically coupled to pad 1121 by a 400 ohm resistor.

### BRIEF DESCRIPTION OF THE DRAWINGS

The present invention may be better understood, and its numerous objects, features, and advantages made apparent to those skilled in the art by referencing the accompanying drawings.
Figure 1 is a circuit diagram of a prior art ESD clamp device with GGNMOS transistors.
Figure 2 is a partial cutaway top view of a portion of a semiconductor die with the clamp device of Figure 1
Figure 3 is a partial cross sectional side view of a semiconductor die showing a prior art GGNMOS transistor.
Figure 4 is a circuit diagram of a semiconductor die showing a GGNMOS clamp device according to one embodiment of the present invention.
Figure 5 is a partial cutaway top view of a semiconductor die with the GGNMOS clamp device of Figure 4 according to one embodiment of the present invention.
Figure 6 is a partial cutaway top view of a portion of a semiconductor die with a GGNMOS clamp device according to one embodiment of the present invention.
Figure 7 is a partial cutaway top view of a portion of a semiconductor die with a GGNMOS clamp device according to one embodiment of the present invention.
Figure 8 is a partial cutaway top view of a portion of a semiconductor die with a GGNMOS clamp device according to one embodiment of the present invention.
Figure 9 is a partial cross-sectional top view of a semiconductor die showing a portion of a GGNMOS clamp device according to one embodiment of the present invention.
Figure 10 is a partial cross-sectional side view of the semiconductor die of Figure 9 showing a portion of the GGNMOS clamp device according to one embodiment of the present invention.
Figure 11 is a second partial cross-sectional side view of the semiconductor die of Figure 9 showing a portion of the GGNMOS clamp device according to one embodiment of the present invention.
Figure 12 is a circuit diagram of a prior art circuit.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

As disclosed herein, an electrostatic discharge circuit includes two or more GGNMOS transistors where each transistor includes two types of body contact regions. Body contact regions of one type are non substrate isolated from body contact regions of the other type. A body contact region of one type is electrically coupled to the source region of its transistor and a body contact region of the other type is electrically connected to at least one other body contact region of the same type of another GGNMOS transistor.

In one embodiment, providing GGNMOS transistors of an ESD circuit with two types of body contact regions and electrically coupling the body contact regions of one type with at least one body contact region of the same type of another GGNMOS transistor may provide for a hole transfer mechanism between the GGNMOS transistors that increases the probability that all GGNMOS transistors of a ESD clamp device will trigger during an ESD event.

An array of GGNMOS (Grounded Gate NMOS) transistors connected in parallel can be used as a clamp device to protect semiconductor devices of a die during an ESD event. When all of the transistors are triggered, the GGNMOS transistors of a clamp device can provide a sufficient sized conductive path from one conductive structure to another to reliably discharge built up ESD charge. In some embodiments, a clamp device utilizes multiple GGNMOS transistors in parallel so that the aspect ratio of the clamp device can be kept within certain limits for die integration feasibility. In some instances, dividing the clamp device up into several smaller GGNMOS transistors connected in parallel may be necessary in order to comply with design guidelines regarding latch up, which require substrate contacts at regular intervals.

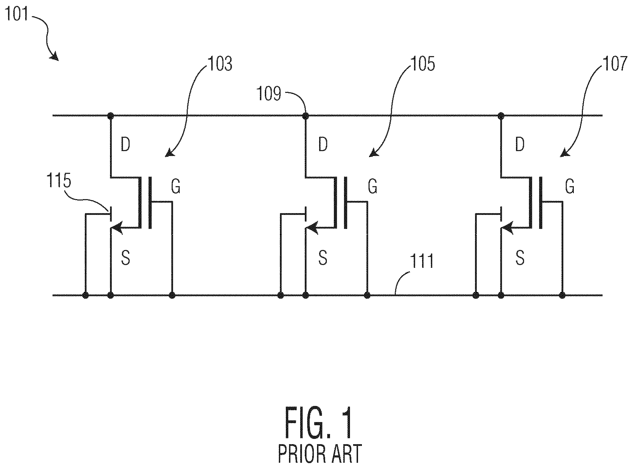

Figure 1 is a prior art circuit diagram of an ESD clamp device 101 that includes three substrate isolated GGNMOS transistors 103, 105, and 107 connected in parallel. When activated during an ESD event, the transistors discharge ESD current affecting line 109 to line 111. The gate and source region of each GGNMOS transistor is electrically connected to line 111 and the drain region of each GGNMOS transistor is electrically connected to line 109. Each GGNMOS transistor includes a body contact region (115 for transistor 103) that is also electrically connected to line 111.

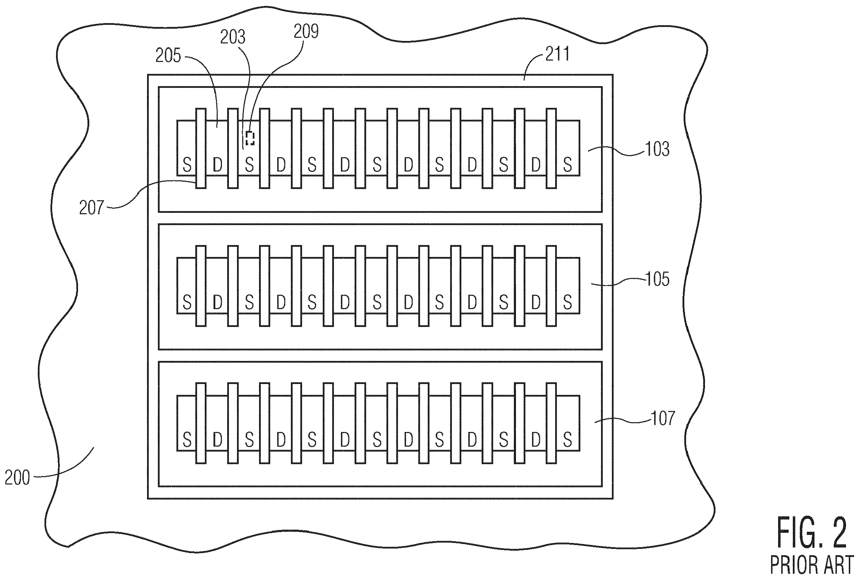

Figure 2 shows a partial cutaway top view of semiconductor die 200 showing portions of GGNMOS transistors 103, 105, and 107. In Figure 2, each GGNMOS transistor includes multiple source, drain, and gate fingers connected in parallel within a substate isolated region. In the view of Figure 2, each of the isolated regions is located in an area defined by substrate contact ring structure 211.

As shown in Figure 2, each transistor (103, 105, and 107) includes multiple source region fingers connected in parallel and multiple drain region fingers connected in parallel (by interconnects not shown in Figure 2). In Figure 2, the source regions are located under source silicide structures (e.g., 203) marked with an "S" and the drain regions are located under drain silicide structures (e.g., 205) marked with a "D." Parallel gate fingers (207) are located between the source silicide structures and drain silicide structures. For each transistor, the gate fingers are also electrically connected by interconnects (not shown).

Each source finger region has one or more opposite conductivity body contact regions (with region 209 shown in dashed lines) located laterally within each source region finger under the source silicide structure (203). The body contact regions are electrically connected to the source finger regions by the source silicide structure (203).

During an ESD event affecting line 109, the voltage differential between line 109 and line 111 may exceed a trigger voltage (e.g., 12 volts) where one or more of transistors 103, 105, and 107 will trigger and become conductive to discharge the ESD current to line 111. Depending on transistor layout and design and on characteristics of the ESD current pulse (e.g., pulse rise time), all or almost all of the isolated GGNMOS transistors of a clamp will trigger independently. In such a condition, the clamp device can sink its designed amount of ESD current in a reliable manner.

However, in some circumstances, only one GGNMOS transistor of a clamp circuit device triggers during an ESD event. When triggered, GGNMOS transistors typically experience a voltage "snapback" where the source-drain voltage drops from the trigger voltage (e.g., 12 V) to a lower holding voltage (e.g., 8 V) and later to an even lower voltage (e.g., 7 V). In a situation where only one isolated GGNMOS transistor initially triggers due to an ESD event, the decrease in source-drain voltage that occurs during snapback may prevent the other GGNMOS transistors from triggering. In certain situations, one isolated GGNMOS transistor of a clamp device may be too small to discharge all of the ESD pulse current safely. Accordingly, under such conditions, ESD protection may fail at a stress level that falls short of its designed target.

Consequently, it may be desirable to provide a multi GGNMOS transistor clamp device where all transistors can be expected to trigger as intended during the initial phase of the ESD event, even when the voltage differential from the event falls below the trigger voltage due to less than all of the transistors initially triggering.

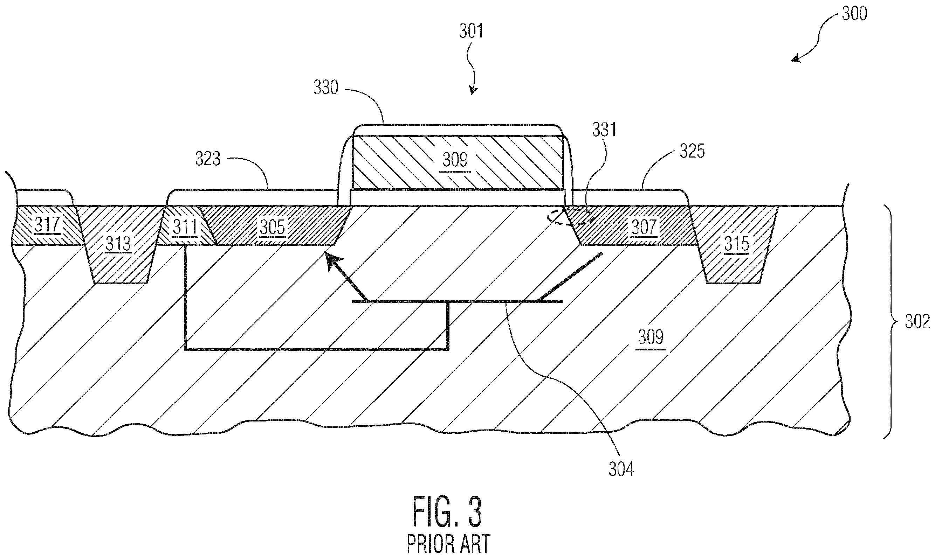

Figure 3 is a partial cross-sectional side view of a semiconductor die 300 including a prior art GGNMOS transistor 301. Transistor 301 includes a gate 330 located over a substrate 302. Substrate 302 includes a source region 305, a drain region 307, a body region 309, a body contact region 311, oxide insulators 313 and 315, and an external body contact region 317 located outside of insulators 313 and 315. A source silicide 323 contacts body contact region 311 and source region 305 to electrically connect the two regions. A drain silicide 325 contacts drain region 307. Not shown is the electrical connection between gate silicide 330 and source silicide 323.

At the onset of an ESD pulse, the p/n junction that forms between drain region 307 and body region 309 is reverse biased. At this point, there is no significant current flow in the transistor. As the voltage differential between the source region 305 and drain region 307 nears the trigger voltage of the GGNMOS transistor 301, impact ionization starts to take place near the body/drain junction (ionization zone 331), resulting in a small amount of current flow (in the mA or in the tens of mA range depending on the size and design of transistor 301). This current includes electrons travelling from the drain/body junction (e.g., from ionization zone 331) towards the drain silicide 325, and includes holes travelling from the drain/body junction towards the body contact region 311. A GGNMOS transistor will trigger when the local current density of holes exiting the transistor via the body contact region 311 (through silicide 323 to a ground rail - not shown), exceeds a critical value which causes the NPN transistor 304 formed of the doped regions in substrate 302 to conduct. At this point, the GGNMOS transistor becomes fully conductive to discharge ESD current from drain silicide 325 to source silicide 323, and exhibits a drop in drain-source voltage commonly referred to as "snapback."

As described above, the holes for triggering a GGNMOS transistor are produced locally by impact ionization from zone 331. However, holes for triggering a GGNMOS transistor can also be produced by other devices and then injected into the body region via a separate path, where they can flow out of the body region via the body contact region for triggering the GGNMOS transistor. In some instances of this triggering condition, the drain-source voltage should be higher than the GGNMOS hold voltage (7 V in the example in Fig. 2) so that the conductive condition can sustain itself.

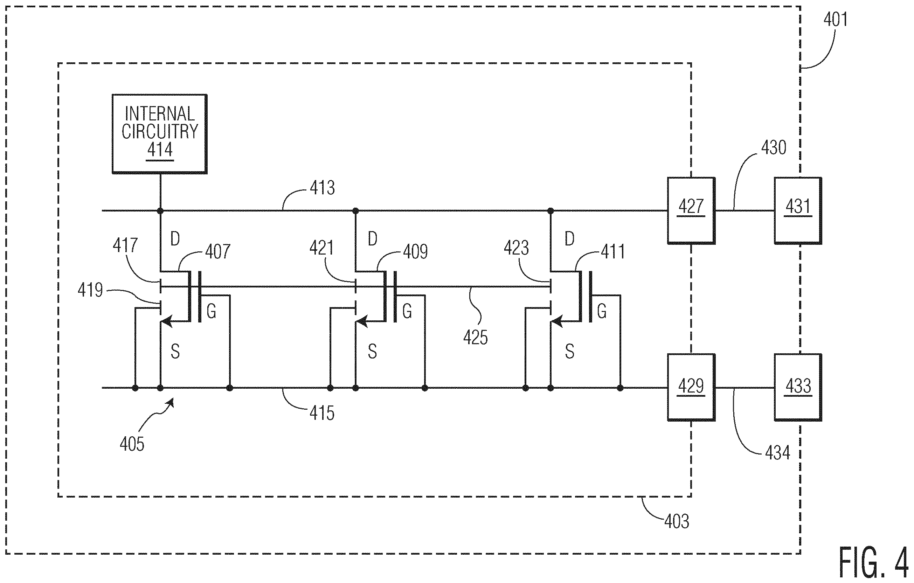

Figure 4 is a circuit diagram of a semiconductor die package 401 that includes a semiconductor die 403. Die 403 includes a self-triggering ESD clamp device 405 that includes three substrate isolated GGNMOS transistors 407, 409, and 411 for discharging ESD current from an ESD event affecting line 413 to line 415. In the embodiment shown, line 413 is electrically connected to die terminal 427 and line 415 is electrically connected to die terminal 429. Die terminal 427 is electrically connected to package terminal 431 by connector 430 (e.g., bond wire, circuit board trace, and/or solder etc.) and die terminal 429 is electrically connected to package terminal 433 by connecter 434.

In one embodiment, die terminal 427 is an I/O die terminal that is used to exchange signals with internal circuitry 414 of die 403 and with circuitry (not shown) external to die 101. In one embodiment, internal circuitry 414 can include digital, analog, mixed signal, sensors, or other types of circuitry. In one embodiment, I/O external die terminals convey digital signals (e.g., such digital data signals), but may also convey analog signals in other embodiments. In one embodiments, I/O external die terminals 427 and 429 are implemented with die pads, but may be implemented with other types of die terminals (e.g., bumps, posts) in other embodiments. In one embodiment, terminal 429 is a ground terminal, but may be configured to convey other power supply voltages in other embodiments. In other embodiments, external die terminal 427 may be a power supply terminal for receiving a supply voltage (e.g., 5 V, 1.8 V, 0 V).

In the embodiment shown, die 403 is encapsulated with an encapsulate (e.g., molding compound, epoxy, or plastic (not shown)) to form semiconductor die package 401 where die 403 can be implemented in an electronic system such as an automobile control system, computer system, industrial control system, cellular phone, or communication device etc. (none shown).

In the embodiment shown, die 403 includes an ESD clamp device 405 that includes three substate isolated GGNMOS transistors 407, 409, and 411. The drain region of each transistor is electrically connected to line 413 and the source region, gate region, and one type of body contact region (e.g., region 419 of transistor 407) is electrically connected to ground. Each transistor includes another type of body contact region (e.g., region 417, region 421, and region 423) that is electrically connected to the same type of body contact region of the other substrate isolated transistors of clamp device 405. In the embodiment shown, the other type of body contact regions (417) are electrically connected by a connector 425 that includes one or more conductive structures (e.g., silicide, conductive vias, and interconnects).

During an ESD event affecting line 413 (e.g., from an ESD event at terminal 427 or terminal 431), charge accumulates at line 413 to increase the voltage above the triggering voltage (e.g., 12 V) of the GGNMOS transistors. For at least one of GGNMOS transistors 407, 409, and 411, holes are generated by impact ionization near the body/drain junction of the transistor such that the number of holes leaving the body region through a body contact region connected to line 415 reaches a critical number that cause the transistor to trigger and conduct. As the triggered transistor continues to conduct, holes are continuously generated by ionization so as to sustain the conductivity of the transistor. The generated holes "leave" the transistor by recombining with electrons sourced from line 415 (e.g., from the body contact region (419) and the source region of the transistor).

Clamp device 405 includes a mechanism to transport holes generated in a triggered transistor to the other transistors for triggering those transistors during an ESD event. Holes generated by a triggered transistor leave the body contact region (417, 421, 423) connected to connector 425 and are transferred to the body contact regions (417, 421, 423) of the other transistors connected to connector 425. The holes enter the body regions of the other transistors and cause the other transistors to become conductive such that all transistors of clamp device 405 are made conductive to discharge the ESD charge on line 413 to line 415. A hole is "transferred" from a first body region to a second body region through a connector by the following physical processes: a first electron received from the connector recombines with a first hole in the first body region near or at the interface between the connector and the first body region, simultaneously or shortly thereafter, a second electron leaves the second body region and enters the connector, replacing the first electron; as the second electron leaves the second body region, it creates (or leaves behind) a second hole in the second body region. Background to these processes can be found in the literature on semiconductor physics under terms "electron-hole pair generation" and "electron-hole recombination."

Once a second transistor is triggered from the transferred holes, that transistor will produce by ionization additional holes that are transferred to the third non conducting transistor to trigger that transistor. Accordingly, during an ESD event that triggers one of transistors 407, 409, and 411, all of the other transistors of clamp device 405 will be triggered to safely conduct ESD current to line 415. Furthermore, in some embodiments, the subsequent triggering of the other GGNMOS transistors though hole transfer can occur when the source drain-voltage of the other transistors is below the trigger voltage of a GGNMOS transistor (e.g., 12 V).

In the embodiment shown, the two types of body contact regions (417 and 419) of a GGNMOS transistor of clamp device 405 are "non substrate isolated" from each other. "Non substrate isolated" means that there is no conductivity path between two structures, devices, or regions outside of any semiconductor material path in the substrate. Accordingly for two body contact regions that are "non substrate isolated" such as body contact regions 417 and 419, is no conductivity path between two regions outside of any semiconductor material path in the substrate.

Providing a GGNMOS clamp device with GGNMOS transistors with two different types of body contact regions that are non substrate isolated may provide for a transistor that will trigger in response to an elevated voltage due to an ESD event from generated holes transferred through one of the body contact regions (419) to a lower voltage (ground) and provide holes to the other transistors of the clamp through the second body contact region (417) to trigger the other transistors of the clamp device. In one example, if the different types of body contact regions were electrically connected together, then a sufficient number of holes may not be transferred to other nonconducting transistors of the clamp circuit to cause those transistors to trigger. In such a case, only part of the clamp circuit would activate to conducts ESD current, possibly resulting in the clamp circuit failing to adequately sink the amount of ESD current it was designed to sink.

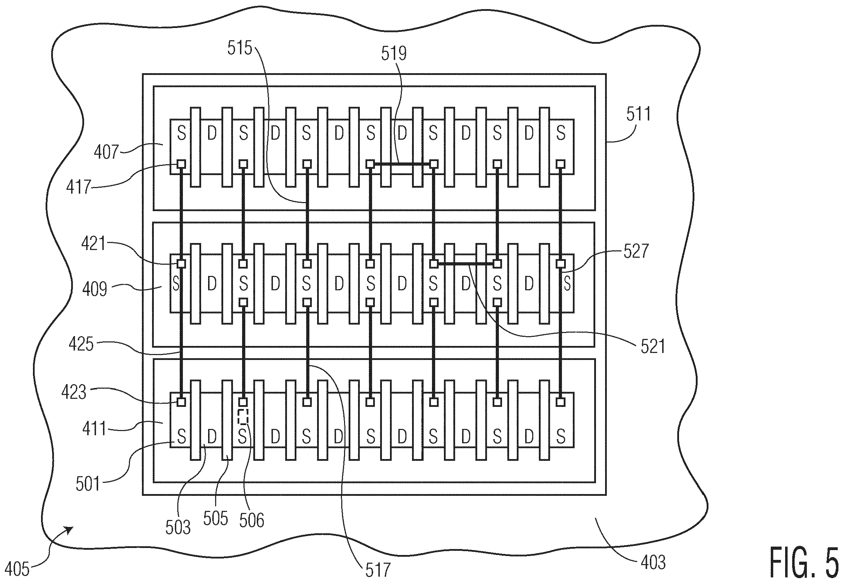

In other embodiments, a body contact region of either type may be located outside of the source or drain regions of a transistor. In one embodiment of Figure 5, body contact regions (not shown) may be located in an area between the source or drain regions and an isolation region or structure (e.g., ring structure 511). For example, referring to Figure 3, body contact region 311 is located outside of source region 305 between source region 305 and isolation trench insulator 313.

Figure 5 shows a partial cutaway top view of semiconductor die 403 showing portions of GGNMOS transistors 407, 409, and 411 according to one embodiment. In the embodiment of Figure 5, each GGNMOS transistor includes multiple source, drain, and gate fingers connected in parallel within a substate isolated region. In the embodiment of Figure 5, each of the isolated regions is located in an area defined by substrate contact ring structure 511. Die 403 may include other substrate isolation regions or structures such as N buried layers, dielectric structures, and opposite conductivity type regions that surround the transistors (not shown).

As shown in Figure 5, each transistor (407, 409, and 411) include multiple source finger regions connected in parallel and multiple drain finger regions connected in parallel (by interconnects not shown in Figure 5). In Figure 5, the source regions are located under source silicide structures (e.g., 501) marked with an "S" and the drain regions are located under drain silicide structures (e.g., 503) marked with a "D." Parallel gate fingers (507) are located between the source silicide structures and drain silicide structures. For each transistor, the gate fingers (505) are also electrically connected by interconnects (not shown). In some embodiments, the gate fingers would include a sidewall spacers (not shown) to separate the gate finger from the source and drain silicide structures.

In the embodiment shown, each source finger has one or more body contact regions (with region 506 shown in dashed lines) of opposite conductivity located laterally within each source finger region and under the source silicide structure. These body contact regions are electrically coupled to the source finger regions by the source silicide structures (501).

Clamp device 405 includes a number of body contact regions (417, 421, and 423) that are located in the substrate of die 403 and are laterally surrounded by the source finger regions. These body contact regions are not covered by a source silicide structure. In one embodiment, other silicide structures are located on top of the body contact regions (417, 421, and 423) and are physically separate from the source silicide structures.

Figure 5 illustrates a number of different ways that a body contact region (423) of GGNMOS clamp device 405 can be electrically connected to other body contact regions for transmitting holes. For example, body contact regions 417, 421, and 423 are each interconnected together with connector 425. Connector 527 also interconnects body contact regions from transistors 407, 409, and 411. Some connectors connect body contact regions from two transistor such as connector 515 and connector 517. Other connectors connect two body contact regions located within two different source finger regions of an isolated transistor. For example, connector 519 connects two body contact regions in transistor 407 and connector 521 connects two body contact regions of transistor 409. Intra transistor connectors (519 and 521) may allow for different parts of a transistor to become conductive more quickly and turn on more homogeneously.

Accordingly, in various embodiments, the body contact regions of different transistors may be electrically connected in different ways such as where a body contact region of all transistors are connected together (connector 425) or where a body contact region is connected to a body contact region of just one other transistor (connectors 517 and 515). In still other embodiments, all of the body contact regions (that are non substate connected to a source region) would be electrically interconnected to a body contact ring bus (not shown) so as to more quickly make conductive the entire GGNMOS clamp device 405.

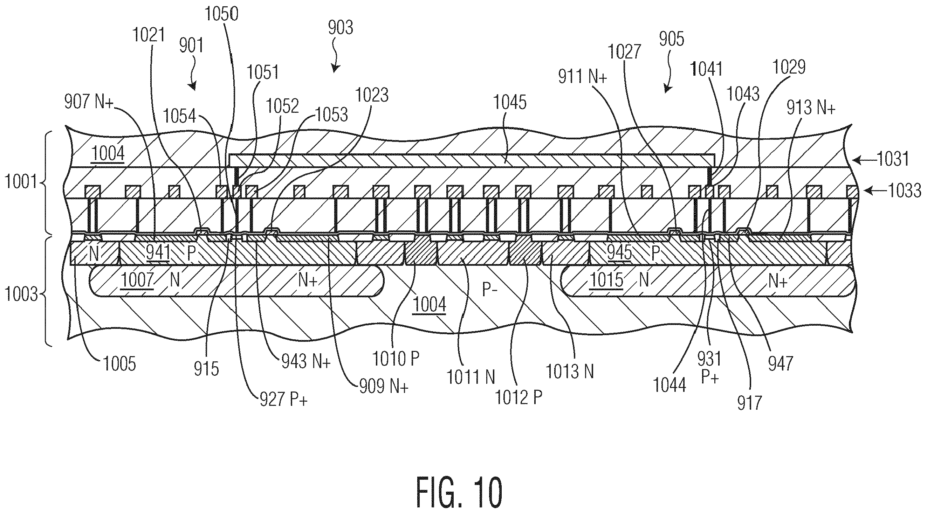

In the embodiment of Figure 5 each body contact region shown is laterally separated from the source finger region by an insulator structure in the substrate. See for example in Figure 10 where body contact region 927 is separated from source region 943 by insulator structure 915.

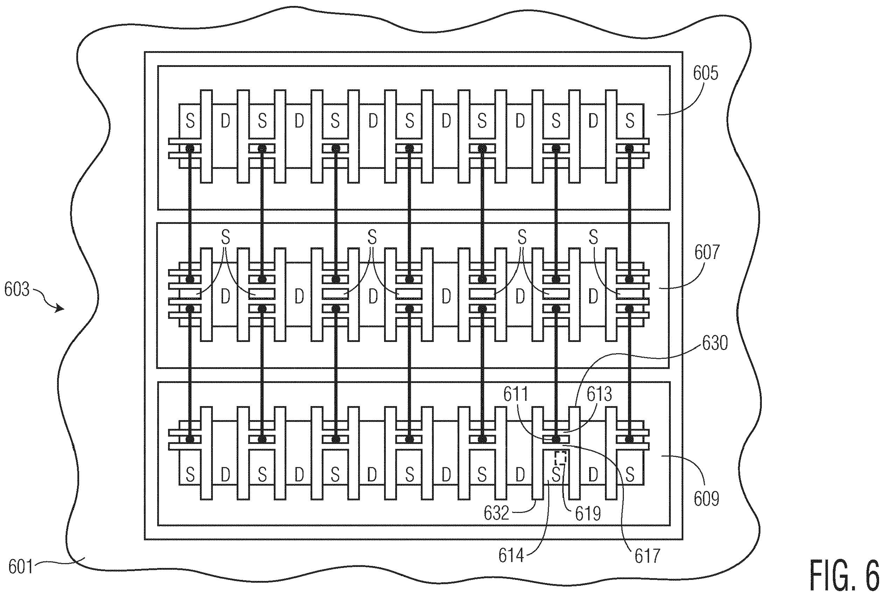

Figure 6 is a partial cutaway top view of a semiconductor die 601 that includes a clamp device 603 with multiple substrate isolated GGNMOS transistors 605, 607, and 609 according to another embodiment of the present invention. In the embodiment of Figure 6, the body contact regions (611) are isolated from the source silicides (614) by gate material extensions 613 and 617 that extend between two adjacent gate fingers 630 and 632. In one embodiment, the gate material is poly silicon, but could be other materials (e.g., a metal) in other embodiments. In some embodiments, sidewall spacers (not shown) would be located on the sidewalls of the gate material structures shown in Figure 6. With gate material laterally surrounding body contact region 611, region 611 is non substrate isolated from source silicide 614. Furthermore, the gate material extensions block N type source dopants or P type body contact region dopants from being implanted into the area of the substrate surrounding body contact region 611. A second body contact region 619 (shown in dashed lines) is located on an opposing side of extension 617 and is electrically connected to source silicide 614.

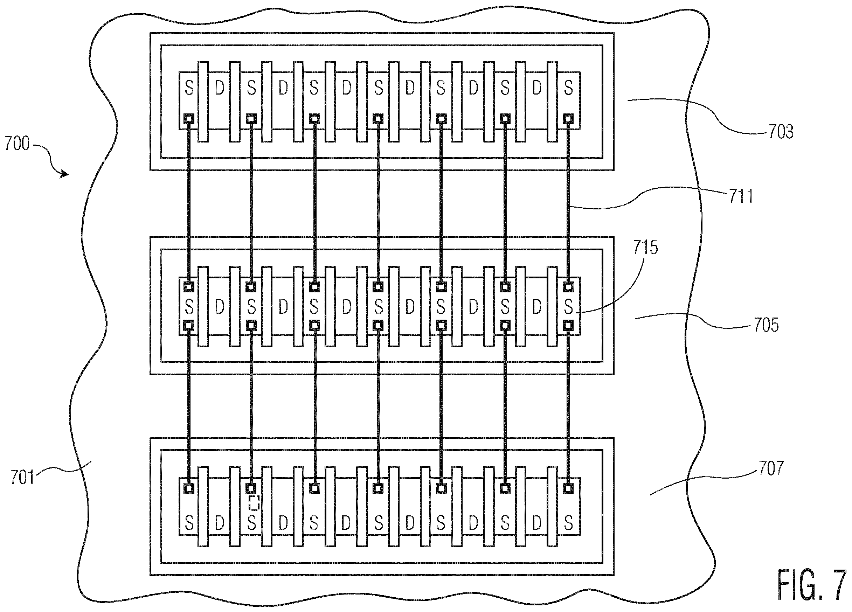

Figure 7 is a partial cutaway top view of a semiconductor die 700 that includes a GGNMOS clamp device 701 with substrate isolated transistors 703, 705, and 707. In the embodiment of Figure 7, each transistor of the clamp device is laterally separated from each other by a separation distance that is greater than the separation distances shown in the other shown embodiments. In the embodiment shown, body contact regions laterally surrounded by source regions of each finger are connected with a connector (711) to a body contact region of another substrate isolated transistor of the clamp device.

In one embodiment, the GGNMOS transistors of a clamp device may be located around a perimeter of a die where the source regions and gate fingers of the transistors of the clamp device are electrically connected to one bus, the drain regions are electrically connected to a second bus, and the body contact regions (shown in Figure 7) are connected to a third bus (not shown). In such a configuration, the triggering of any one GGNMOS transistor on a perimeter will trigger all of the transistors on the perimeter.

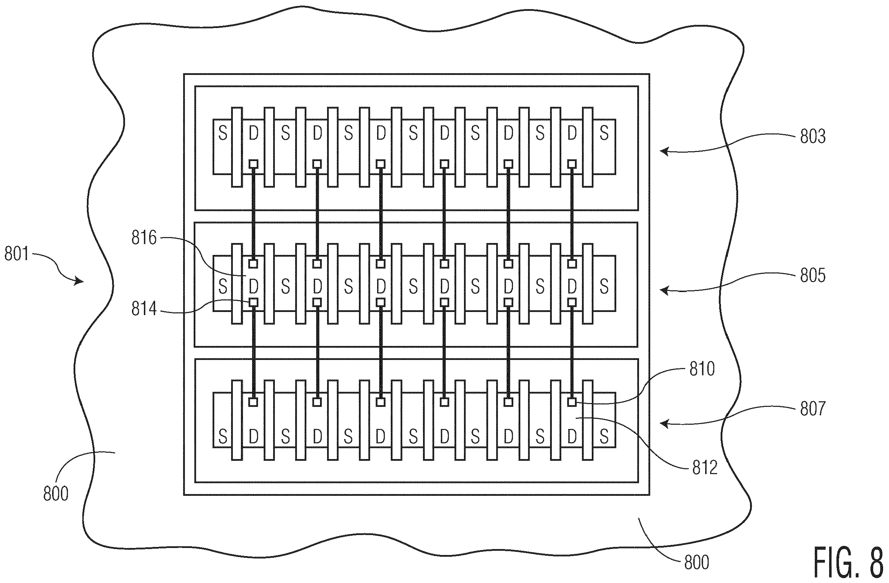

Figure 8 is a partial cutaway top view of a semiconductor die 800 that includes a GGNMOS clamp device 801 with substrate isolated transistors 803, 805, and 807. In the embodiment of Figure 8, the interconnected body contact regions (810, 814) are laterally surrounded by the drain regions located under the drain silicide structures (812, 816, respectively) shown in Figure 8. In the embodiment shown, the interconnected body contact regions are physically separated from the drain regions by an insulator located in the substrate. Also, the drain silicide structures (816) are separated from the silicide structures on the interconnected body contact regions (814).

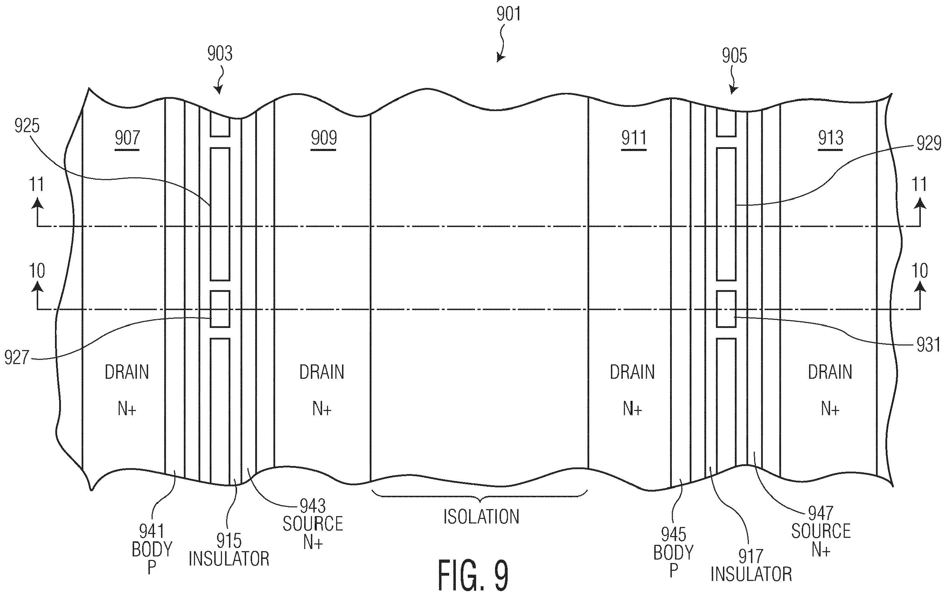

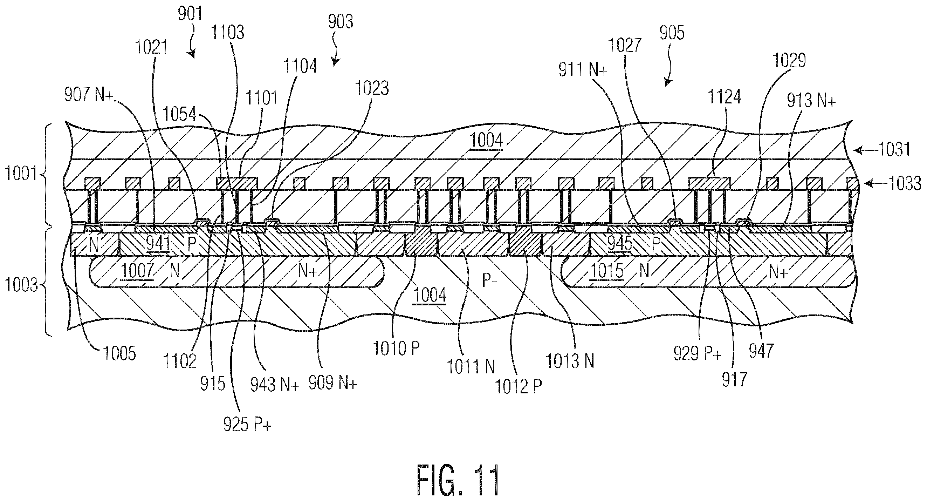

Figure 9 is a partial cross-sectional top view of a semiconductor die 901 that includes two substrate isolated GGNMOS transistors 903 and 905 of a GGNMOS device clamp. In the embodiment shown, each transistor includes two N type conductivity doped drain finger regions (regions 907 and 909 for transistor 903 and regions 911 and 913 for transistor 905) laterally located on opposite sides of a single N type source region (source region 943 for transistor 903 and source region 947 for transistor 905). Each transistor includes two gate fingers ( with fingers 1021, 1023, 1027 and 1029 shown in Figures 10 and 11) located over the P type body regions (941 and 945) between the drain finger regions (907, 909, 911, and 913) and opposing sides of the source regions (943 and 947). Isolation structures (shown in Figures 10 and 11) are laterally located between transistors 903 and 905.

Figure 9 shows the two types of body contact regions that are separated by insulator structure 915. The first type (contact regions 927 and 931) are electrically connected together (see the cross section shown in Figure 10). The second type (contact regions 925 and 929) are electrically connected to source regions 943 and 947, respectively (see the cross section shown in Figure 11).

Figure 10 is a partial cross sectional side view of semiconductor die 901 at a location of body contact regions 927 and 931. Die 901 includes a semiconductor substrate 1003 with regions of different net conductivity doping types and with dielectric structures (e.g., isolation structure 915). As used herein, the designation of a semiconductor region as an "N" or "P" or as "N type" or "P type" denotes the net conductivity dopant concentration of the region. An "N" or "N type" indicates that the region has a net N type conductivity dopant concentration (e.g., of phosphorous, arsenic) and a "P" or "P type" indicates that the region as a net P type conductivity dopant concentration (e.g., of boron). The designations of 1) "+," 2) "-," or 3) no designation of "+" or "-" next to the N or P indicates the relative net concentration of the net conductivity dopant concentration. A "+" indicates a higher net concentration than no designation of "+" or "-," and a "-" indicates a lower net concentration than no designation of "+" or "-." These regions of different conductivity dopant concentrations can be formed by one or more conductivity dopant ion implantation processes, be formed in-situ during semiconductor material formation, or be formed by dopant diffusion from other regions. In one embodiment, a region with a designation of "P+" has a net conductivity dopant concentration in the range of .5-2E10²⁰ per cm³. A region with a designation of "P" has a net conductivity dopant concentration in the range of .05-2E10¹⁸ per cm³. A region with a designation of "P-" has a net conductivity dopant concentration in the range of .5-2E10¹⁴ per cm³. A region with a designation of "N+" has a net conductivity dopant concentration in the range of .5-2E10²⁰ per cm³. A region with a designation of "N" has a net conductivity dopant concentration in the range of .5-2E10¹⁸ per cm³. A region with a designation of "N-" has a net conductivity dopant concentration in the range of .05-2E10¹⁷ per cm³. However, these designations may represent other doping concentration values in other embodiments. Also, the identified regions in the Figures may have other relative doping concentrations in other embodiments.

In one embodiment, substrate 1003 includes semiconductor material (e.g., silicon, silicon germanium, silicon carbide, gallium nitride, other III-V semiconductor material) and may include dielectric structures e.g., buried oxide layers or shallow trench isolation structures 915 and 917. Substrate 1003 may also include other semiconductor devices (not shown) located outside the view of Figure 2.

Die 901 includes an interconnect portion 1001 that includes one or more layers of dielectric material 1004 that are located above substrate 1003. Interconnect portion 1001 includes multiple conductive interconnect layers (with interconnect layers 1031 and 1033 being shown) for electrically connecting the devices of die 901 to each other and to external circuitry (not shown). Portion 1001 also includes conductive vias (e.g., vias 1041, 1044, 1050, and 1051) for electrically connecting the interconnect layers and silicided regions together. In one embodiment, the interconnects and vias are made of one or more layers of conductive material (e.g., copper, tungsten, titanium, gold, aluminum). In one embodiment, die 901 may include additional interconnect layers (not shown) located above layer 1031.

Body region 941 of transistor 903 is laterally surrounded by an N type isolation region 1005 and is located above an N type buried region 1007 that is in contact with region 1005. Body region 945 of transistor 905 is laterally surrounded by an N type isolation region 1013 and is located above an N type buried region 1015 that is in contact with region 1013. These isolations regions separate the P type body regions from other P type regions (e.g., P- region 1004). Region 1004 is biased by P type contact regions 1010 and 1012. During operation, N type regions 1005 and 1013 and P type regions 1010 and 1012 are reversed biased to prevent current from flowing between transistors 903 and 905. However other embodiments may include other types of isolation structures for restricting current flow between the GGNMOS transistors of a GGNMOS clamp device.

In the embodiment of Figure 10, body contact region 927 is laterally surrounded by isolation structure 915 and body contact region 931 is laterally surrounded by isolation structure 917. In one embodiment, structures 915 and 917 are trench oxide isolation structures. No silicide is formed on structures 915 and 917 during a silicidation process such that the silicide structures formed on body contact regions 927 and 931 are physically separate from the silicide structures formed on source regions 943 and 947.

In the embodiment shown, body contact region 927 of transistor 903 is electrically connected body contact region 931 of transistor 905 through a silicide structure (not shown) on region 927, via 1050, interconnect structure 1052, via 1054, interconnect structure 1045, via 1041, interconnect structure 1043, via 1044, and a silicide structure (not shown) on region 931. During operation, if either transistor 903 or 905 triggers due to an ESD event, holes are transferred from the body contact region (927, 931) of the triggered transistor to the body contact region of the other transistor through the above described electrical connection.

Figure 11 is a partial cross-sectional side view of semiconductor die 901 at a location through body contact regions 925 and 929. In the embodiment shown, regions 925 and 929 are laterally surrounded and physically separated from source regions 943 and 947, respectively, by insulator structures 915 and 917 respectively.

In the embodiment shown, body contact region 925 is electrically connected to source region 943 through a silicide on top of region 925 (not shown), via 1103, interconnect 1101, vias 1102 and 1104, and a silicide on top of region 943 (not shown). Body contact region 929 is electrically coupled to source region 947 through interconnect 1124 in a similar manner.

In other embodiments, an GGNMOS clamp device may be configured in other manners, have other structures, and/or transfer holes by other mechanisms. For example, body contact regions 925 and 929 may be electrically connected to source regions 943 and 947 by source silicide structures (not shown) where isolation structures 915 and 917 do not laterally surround body contact regions 925 and 929, respectively. In other embodiments, an isolated GGNMOS transistor may include two source fingers located on opposite sides of a drain region. In other embodiments, a GGNMOS transistor may only include one gate finger. In still other embodiments, a GGNMOS clamp device may include several substrate isolated transistors (e.g., 4 or more) having body contact regions electrically interconnected.

In some embodiments, providing a GGNMOS clamp device with GGNMOS transistors having two types of body contact regions non substrate isolated from each other, where the contact regions of one type are electrically connected to at least a body contact region of the same type of another transistor, may provide for a clamp device where the triggering of one transistor can generate holes to trigger the other transistors, even if the source to drain voltage drops below the trigger voltage. On the other hand, if a GGNMOS transistor has only one body contact region that is coupled to both a lower voltage line and to other body regions of other GGNMOS transistors, a sufficient number of holes may not be transferred to trigger the other transistors of the clamp device during an ESD event.

Two transistors are substrate isolated where there is no same dopant type conductivity path between the body regions of the transistors.

As disclosed herein, a first structure or region is "directly over" a second structure or region if the first structure or region is located over the second structure or region in a line having a direction that is perpendicular with the generally planar major side of the substrate. For example, in Figure 10, interconnect 1045 is directly over region 1011. Interconnect 1043 is not directly over region 1005. As disclosed herein, a first structure or region is "directly beneath" a second structure or region if the first structure or region is located beneath the second structure region in a line having a direction that is perpendicular with the generally planar major side of the substrate. For example, in Figure 10, region 1007 is directly beneath interconnect 1045. Region 1011 is not directly beneath interconnect 1043. One structure or region is "directly between" two other structures or regions in a line if the two structures or regions are located on opposite sides of the one structure or region in the line. For example, in Figure 10, region 1011 is located directly between region 941 and region 1013 in a horizontal line. Interconnect 1045 is not located directly between region 941 and region 945 in a line. A first structure or region is "directly lateral" to a second structure or region if the first structure or region and second structure or region are located in a line having a direction that is parallel with a generally planar major side of the substrate. For example, region 941 and region 945 are directly lateral to each other. Interconnect 1043 is not directly lateral to region 941. One structure or region is "directly laterally between" two other structures or regions if the two structures or regions are located on opposite sides of the one structure or region in a line that is parallel with a generally planar major side of the substrate. For example, in Figure 10, region 1011 is located directly laterally between region 941 and region 945. A first structure or region laterally surrounds a second structure or region if the first structure or region surrounds the second structure or region in a line having a direction that is parallel with a generally planar major side of the substrate. A vertical line is a line that is perpendicular with a generally planar major side of the substrate.

Features specifically shown or described with respect to one embodiment set forth herein may be implemented in other embodiments set forth herein.

In one embodiment, An electrostatic discharge (ESD) circuit includes a first grounded gate NMOS (GGNMOS) transistor. The first GGNMOS transistor includes a body region in a substrate, a source region in the substrate, and a first body contact region electrically connected to the body region of the first GGNMOS transistor and electrically coupled to the source region of the first GGNMOS transistor. The First GGNMOS transistor includes a second body contact region electrically connected to the body region of the first GGNMOS transistor and non substrate isolated from first body contact region of the first GGNMOS transistor. The ESD circuit includes a second GGNMOS transistor that includes a body region in the substrate, a source region in the substrate, and a first body contact region electrically connected to the body region of the second GGNMOS transistor and electrically coupled to the source region of the second GGNMOS transistor. The second GGNMOS transistor includes a second body contact region electrically connected to the body region of the second GGNMOS transistor and non substrate isolated from first body contact region of the second GGNMOS transistor. The second body contact region of the first GGNMOS transistor is electrically connected to the second body contact region of the second GGNMOS transistor.

In another embodiment, a semiconductor die includes a first line, a second line, and a clamp device for electrically connecting the first line to the second line to discharge ESD current from the first line to the second line during an ESD event affecting the first line. The clamp device includes a first grounded gate NMOS (GGNMOS) transistor including a body region in a substrate, a drain region in the substrate electrically coupled to the first line, a source region in the substrate electrically coupled to the second line, and a first body contact region electrically connected to the body region of the first GGNMOS transistor and electrically coupled to the source region of the first GGNMOS transistor. The first GGNMOS transistor includes a second body contact region electrically connected to the body region of the first GGNMOS transistor and non substrate isolated from first body contact region of the first GGNMOS transistor. The clamp device includes a second GGNMOS transistor including a drain region in the substrate electrically coupled to the first line, a body region in the substrate, a source region in the substrate electrically coupled to the second line, and a first body contact region electrically connected to the body region of the second GGNMOS transistor and electrically coupled to the source region of the second GGNMOS transistor. The second GGNMOS transistor includes a second body contact region electrically connected to the body region of the second GGNMOS transistor and non substrate isolated from first body contact region of the second GGNMOS transistor. The second body contact region of the first GGNMOS transistor is electrically connected to the second body contact region of the second GGNMOS transistor.

An electrostatic discharge (ESD) circuit includes a first grounded gate NMOS (GGNMOS) transistor including a body region in a substrate, a drain region in the substrate, a source region in the substrate, and a first body contact region electrically connected to the body region of the first GGNMOS transistor and electrically coupled to the source region of the first GGNMOS transistor. The first GGNMOS transistor includes a second body contact region electrically connected to the body region of the first GGNMOS transistor and non substrate isolated from first body contact region of the first GGNMOS transistor. The ESD circuit includes a second GGNMOS transistor substrate isolated from the first GGNMOS transistor. The second GGNMOS transistor includes a body region in the substrate, a drain region in the substrate, a source region in the substrate, a first body contact region electrically connected to the body region of the second GGNMOS transistor and electrically coupled to the source region of the second GGNMOS transistor. The second GGNMOS transistor includes a second body contact region electrically connected to the body region of the second GGNMOS transistor and non substrate isolated from first body contact region of the second GGNMOS transistor. The second body contact region of the first GGNMOS transistor is electrically connected to the second body contact region of the second GGNMOS transistor by at least an interconnect. The ESD circuit includes a first line, the drain region of the first GGNMOS transistor and the drain region of the second GGNMOS transistor are electrically coupled to the first line. The ESD circuit includes a second line, the source region of the first GGNMOS transistor and the source region of the second GGNMOS transistor are electrically coupled to the second line.

One or more embodiments of the present disclosure may include features recited in the following numbered clauses:
1. An electrostatic discharge (ESD) circuit comprising: a first grounded gate NMOS (GGNMOS) transistor including: a body region in a substrate; a source region in the substrate; a first body contact region electrically connected to the body region of the first GGNMOS transistor and electrically coupled to the source region of the first GGNMOS transistor; a second body contact region electrically connected to the body region of the first GGNMOS transistor and non substrate isolated from first body contact region of the first GGNMOS transistor; a second GGNMOS transistor including: a body region in the substrate; a source region in the substrate; a first body contact region electrically connected to the body region of the second GGNMOS transistor and electrically coupled to the source region of the second GGNMOS transistor; a second body contact region electrically connected to the body region of the second GGNMOS transistor and non substrate isolated from first body contact region of the second GGNMOS transistor; wherein the second body contact region of the first GGNMOS transistor is electrically connected to the second body contact region of the second GGNMOS transistor.
2. The circuit of clause 1 wherein the source region of the first GGNMOS transistor is electrically coupled to the source region of the second GGNMOS transistor.
3. The circuit of clause 1 wherein: the source region of the first GGNMOS transistor is located in the substrate laterally on at least two opposing sides of the second body contact region of the first GGNMOS transistor; the source region of the second GGNMOS transistor is located in the substrate laterally on at least two opposing sides of the second body contact region of the second GGNMOS transistor.
4. The circuit of clause 1 wherein: the first GGNMOS transistor includes a drain region; the second GGNMOS transistor includes a drain region; the drain region of the first GGNMOS transistor is located in the substrate laterally on at least two opposing sides of the second body contact region of the first GGNMOS transistor; the drain region of the second GGNMOS transistor is located in the substrate laterally on at least two opposing sides of the second body contact region of the second GGNMOS transistor.
5. The circuit of clause 1 wherein: the first GGNMOS transistor includes a drain region electrically coupled to a first line; the second GGNMOS transistor includes a drain region electrically coupled to the first line; the source region of the first GGNMOS transistor is electrically coupled to a second line; the source region of the second GGNMOS transistor is electrically coupled to a second line.
6. The circuit of clause 5 wherein during an ESD event affecting the first line, the first GGNMOS transistor and the second GGNMOS transistor are conductive to discharge ESD current to the second line.
7. The circuit of clause 5, wherein during an ESD event where the first GGNMOS transistor becomes conductive, holes from the body region of the first GGNMOS transistor transfer through the second body contact region of the first GGNMOS transistor, through the second body contact region of the second GGNMOS transistor, to the body region of the second GGNMOS transistor.
8. The circuit of clause 1 further comprising: a third GGNMOS transistor including: a body region in the substrate; a source region in the substrate; a first body contact region electrically connected to the body region of the third GGNMOS transistor and electrically coupled to the source region of the third GGNMOS transistor; a second body contact region electrically connected to the body region of the third GGNMOS transistor and non substrate isolated from first body contact region of the third GGNMOS transistor; wherein the second body contact region of the third GGNMOS transistor is electrically connected to the second body contact region of the first GGNMOS transistor.
9. The circuit of clause 1 further comprising: a gate material structure located directly over a first area of the body region of the first GGNMOS transistor, the first area located directly laterally between the first body contact region of the first GGNMOS transistor and the second body contact region of the first GGNMOS transistor.
10. The circuit of clause 1 wherein the first GGNMOS transistor is substrate isolated from the second GGNMOS transistor.
11. The circuit of clause 10 wherein the first GGNMOS transistor includes a third body contact region electrically connected to the body region of the first GGNMOS transistor, electrically connected to the second body contact region of the first GGNMOS transistor by at least an interconnect, and non substrate isolated from first body contact region of the first GGNMOS transistor.
12. A semiconductor die comprising: a first line; a second line; a clamp device for electrically connecting the first line to the second line to discharge ESD current from the first line to the second line during an ESD event affecting the first line, the clamp device including: a first grounded gate NMOS (GGNMOS) transistor including: a body region in a substrate; a drain region in the substrate electrically coupled to the first line; a source region in the substrate electrically coupled to the second line; a first body contact region electrically connected to the body region of the first GGNMOS transistor and electrically coupled to the source region of the first GGNMOS transistor; a second body contact region electrically connected to the body region of the first GGNMOS transistor and non substrate isolated from first body contact region of the first GGNMOS transistor; a second GGNMOS transistor including: a drain region in the substrate electrically coupled to the first line; a body region in the substrate; a source region in the substrate electrically coupled to the second line; a first body contact region electrically connected to the body region of the second GGNMOS transistor and electrically coupled to the source region of the second GGNMOS transistor; a second body contact region electrically connected to the body region of the second GGNMOS transistor and non substrate isolated from first body contact region of the second GGNMOS transistor; wherein the second body contact region of the first GGNMOS transistor is electrically connected to the second body contact region of the second GGNMOS transistor.
13. The semiconductor die of clause 12 wherein the first GGNMOS transistor is substrate isolated from the second GGNMOS transistor.
14. The semiconductor die of clause 12 wherein: the source region of the first GGNMOS transistor is located in the substrate laterally on at least two opposing sides of the second body contact region of the first GGNMOS transistor; the source region of the second GGNMOS transistor is located in the substrate laterally on at least two opposing sides of the second body contact region of the second GGNMOS transistor.
15. The semiconductor die of clause 12 wherein: the drain region of the first GGNMOS transistor is located in the substrate laterally on at least two opposing sides of the second body contact region of the first GGNMOS transistor; the drain region of the second GGNMOS transistor is located in the substrate laterally on at least two opposing sides of the second body contact region of the second GGNMOS transistor.
16. The semiconductor die of clause 12 wherein holes are transferable between the second body contact region of the first GGNMOS transistor and the second body contact region of the second GGNMOS transistor during an ESD event affecting the first line.
17. The semiconductor die of clause 12 further comprising: a third GGNMOS transistor including: a drain region in the substrate electrically coupled to the first line; a body region in the substrate; a source region in the substrate electrically coupled to the second line; a first body contact region electrically connected to the body region of the third GGNMOS transistor and electrically coupled to the source region of the third GGNMOS transistor; a second body contact region electrically connected to the body region of the third GGNMOS transistor and non substrate isolated from first body contact region of the third GGNMOS transistor; wherein the second body contact region of the third GGNMOS transistor is electrically connected to the second body contact region of the first GGNMOS transistor.
18. The semiconductor die of clause 12 wherein: the first GGNMOS transistor is substrate isolated from the second GGNMOS transistor; the first GGNMOS transistor includes a third body contact region electrically connected to the body region of the first GGNMOS transistor, electrically connected to the second body contact region of the first GGNMOS transistor by at least an interconnect (519), and non substrate isolated from first body contact region of the first GGNMOS transistor.
19. The semiconductor die of clause 12 further comprising: a gate material structure located directly over a first area of the body region of the first GGNMOS transistor, the first area located directly laterally between the first body contact region of the first GGNMOS transistor and the second body contact region of the first GGNMOS transistor.
20. An electrostatic discharge (ESD) circuit comprising: a first grounded gate NMOS (GGNMOS) transistor including: a body region in a substrate; a drain region in the substrate; a source region in the substrate; a first body contact region electrically connected to the body region of the first GGNMOS transistor and electrically coupled to the source region of the first GGNMOS transistor; a second body contact region electrically connected to the body region of the first GGNMOS transistor and non substrate isolated from first body contact region of the first GGNMOS transistor; a second GGNMOS transistor substrate isolated from the first GGNMOS transistor, the second GGNMOS transistor including: a body region in the substrate; a drain region in the substrate; a source region in the substrate; a first body contact region electrically connected to the body region of the second GGNMOS transistor and electrically coupled to the source region of the second GGNMOS transistor; a second body contact region electrically connected to the body region of the second GGNMOS transistor and non substrate isolated from first body contact region of the second GGNMOS transistor; wherein the second body contact region of the first GGNMOS transistor is electrically connected to the second body contact region of the second GGNMOS transistor by at least an interconnect; a first line, the drain region of the first GGNMOS transistor and the drain region of the second GGNMOS transistor are electrically coupled to the first line; a second line, the source region of the first GGNMOS transistor and the source region of the second GGNMOS transistor are electrically coupled to the second line.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the scope of this invention.

## Claims

1. An electrostatic discharge (ESD) circuit comprising:
a first grounded gate NMOS (GGNMOS) transistor including:
a body region in a substrate;
a source region in the substrate;
a first body contact region electrically connected to the body region of the first GGNMOS transistor and electrically coupled to the source region of the first GGNMOS transistor;
a second body contact region electrically connected to the body region of the first GGNMOS transistor and non substrate isolated from first body contact region of the first GGNMOS transistor;
a second GGNMOS transistor including:
a body region in the substrate;
a source region in the substrate;
a first body contact region electrically connected to the body region of the second GGNMOS transistor and electrically coupled to the source region of the second GGNMOS transistor;
a second body contact region electrically connected to the body region of the second GGNMOS transistor and non substrate isolated from first body contact region of the second GGNMOS transistor;
wherein the second body contact region of the first GGNMOS transistor is electrically connected to the second body contact region of the second GGNMOS transistor.

2. The circuit of claim 1 wherein the source region of the first GGNMOS transistor is electrically coupled to the source region of the second GGNMOS transistor.

3. The circuit of claim 1 or 2 wherein:
the source region of the first GGNMOS transistor is located in the substrate laterally on at least two opposing sides of the second body contact region of the first GGNMOS transistor;
the source region of the second GGNMOS transistor is located in the substrate laterally on at least two opposing sides of the second body contact region of the second GGNMOS transistor.

4. The circuit of any of claims 1 to 3 wherein:
the first GGNMOS transistor includes a drain region;
the second GGNMOS transistor includes a drain region;
the drain region of the first GGNMOS transistor is located in the substrate laterally on at least two opposing sides of the second body contact region of the first GGNMOS transistor;
the drain region of the second GGNMOS transistor is located in the substrate laterally on at least two opposing sides of the second body contact region of the second GGNMOS transistor.

5. The circuit of any of claims 1 to 4 wherein:
the first GGNMOS transistor includes a drain region electrically coupled to a first line;
the second GGNMOS transistor includes a drain region electrically coupled to the first line;
the source region of the first GGNMOS transistor is electrically coupled to a second line;
the source region of the second GGNMOS transistor is electrically coupled to a second line.

6. The circuit of claim 5 wherein during an ESD event affecting the first line, the first GGNMOS transistor and the second GGNMOS transistor are conductive to discharge ESD current to the second line.

7. The circuit of claim 5, wherein during an ESD event where the first GGNMOS transistor becomes conductive, holes from the body region of the first GGNMOS transistor transfer through the second body contact region of the first GGNMOS transistor, through the second body contact region of the second GGNMOS transistor, to the body region of the second GGNMOS transistor.

8. The circuit of any of claims 1 to 8 further comprising:
a third GGNMOS transistor including:
a body region in the substrate;
a source region in the substrate;
a first body contact region electrically connected to the body region of the third GGNMOS transistor and electrically coupled to the source region of the third GGNMOS transistor;
a second body contact region electrically connected to the body region of the third GGNMOS transistor and non substrate isolated from first body contact region of the third GGNMOS transistor;
wherein the second body contact region of the third GGNMOS transistor is electrically connected to the second body contact region of the first GGNMOS transistor.

9. The circuit of any of claims 1 to 7 further comprising:
a gate material structure located directly over a first area of the body region of the first GGNMOS transistor, the first area located directly laterally between the first body contact region of the first GGNMOS transistor and the second body contact region of the first GGNMOS transistor.

10. The circuit of any of claims 1 to 9 wherein the first GGNMOS transistor is substrate isolated from the second GGNMOS transistor.

11. The circuit of claim 10 wherein the first GGNMOS transistor includes a third body contact region electrically connected to the body region of the first GGNMOS transistor, electrically connected to the second body contact region of the first GGNMOS transistor by at least an interconnect, and non substrate isolated from first body contact region of the first GGNMOS transistor.

12. A semiconductor die comprising:
a first line;
a second line;
a clamp device for electrically connecting the first line to the second line to discharge ESD current from the first line to the second line during an ESD event affecting the first line, the clamp device including:
a first grounded gate NMOS (GGNMOS) transistor including:
a body region in a substrate;
a drain region in the substrate electrically coupled to the first line;
a source region in the substrate electrically coupled to the second line;
a first body contact region electrically connected to the body region of the first GGNMOS transistor and electrically coupled to the source region of the first GGNMOS transistor;
a second body contact region electrically connected to the body region of the first GGNMOS transistor and non substrate isolated from first body contact region of the first GGNMOS transistor;
a second GGNMOS transistor including:
a drain region in the substrate electrically coupled to the first line;
a body region in the substrate;
a source region in the substrate electrically coupled to the second line;
a first body contact region electrically connected to the body region of the second GGNMOS transistor and electrically coupled to the source region of the second GGNMOS transistor;
a second body contact region electrically connected to the body region of the second GGNMOS transistor and non substrate isolated from first body contact region of the second GGNMOS transistor;
wherein the second body contact region of the first GGNMOS transistor is electrically connected to the second body contact region of the second GGNMOS transistor.

13. The semiconductor die of claim 12 wherein the first GGNMOS transistor is substrate isolated from the second GGNMOS transistor.

14. The semiconductor die of claim 12 or 13, wherein:
the source region of the first GGNMOS transistor is located in the substrate laterally on at least two opposing sides of the second body contact region of the first GGNMOS transistor;
the source region of the second GGNMOS transistor is located in the substrate laterally on at least two opposing sides of the second body contact region of the second GGNMOS transistor.

15. The semiconductor die of any of claim 12 to 14, wherein:
the drain region of the first GGNMOS transistor is located in the substrate laterally on at least two opposing sides of the second body contact region of the first GGNMOS transistor;
the drain region of the second GGNMOS transistor is located in the substrate laterally on at least two opposing sides of the second body contact region of the second GGNMOS transistor.
